# EUROPEAN PATENT APPLICATION

(11) **EP 4 039 848 A1**
(43) Date of publication of application: **10.08.2022**
(21) Application number: 21155800.2
(22) Date of filing: 08.02.2021
(51) Int. Cl.: C23C 16/26, C23C 16/01, C03C 17/22, C01B 32/19

(54) **USE OF GRAPHENE AND OTHER 2D MATERIALS FOR THE IMPROVEMENT OF PROPERTIES OF COMMERCIAL GLAZING AND SHOWCASES**

(71) Applicant: Foundation of Research and Technology Institute of Chemical Engineering Sciences, 26504 Patras (GR)
(72) Inventor: Galiotis, Costas, 26504 Patras (GR); Anagnostopoulos, Giorgos, 26504 Patras (GR); Pastore Carbone, Maria Giovanna, 26504 Patras (GR); Paterakis, Giorgos, 26504 Patras (GR); Kotsidi, Maria, 26504 Patras (GR); Gorgolis, Giorgos, 26504 Patras (GR)
(74) Representative: Weickmann & Weickmann PartmbB

(57) **Abstract**

The invention relates to the use of a protective graphene coating for providing protection for a two- or three dimensional artwork or a colored surface against color degradation, especially fading, yellowing and discoloration, due to exposure to UV radiation or other radiation, the use comprising applying the graphene coating onto a glassy surface, which is or will be situated between the artwork and the source of radiation, by a method comprising the following steps:
a) depositing, preferably by chemical vapor deposition (CVD), graphene onto a at least one side of a supporting substrate to produce a graphene/substrate composite including a continuous graphene membrane formed on at least one side of said substrate;
b) removing the substrate, or lifting off the graphene from the substrate and
c) depositing the graphene membrane onto the surface.

Furthermore, the invention relates to protective screens or display case, which comprise a glassy material at least one surface of which is coated by a protective graphene coating.

## Description

The present invention relates to a use of a protective coating for providing protection for a two- or three-dimensional artwork or colored surface against color degradation, especially fading, yellowing and discoloration, due to exposure to UV radiation or other radiation by applying such graphene coating onto at least one surface of a glassy material to be situated between the artwork or colored surface and the source of radiation. The invention further relates to protective screens or display cases comprising such coated glassy material which screens can be used to shield artwork from detrimental environmental influences. The invention further relates to uses of the protective screen for the preservation of two- or three-dimensional artwork.

### Technical background

The technical field of the invention is the protection of artwork, i.e. paintings but also other objects of any kind and form. All art materials are prone to environmental degradation. In particular, the introduction of new production techniques, mainly in the 20^{th} century, has reduced their lifespan. Fading, yellowing and discoloration are the most common decomposition effects resulting from exposure to ultraviolet and visible light, as well as oxidizing agents. These effects of aging mechanisms lead to a serious and irreversible deterioration in the readability of works of art, which are an invaluable legacy of mankind. The idea that there have been so many famous paintings for 100 years or 500 years without having altered is false. Recently, it has been revealed that e.g. the red lead pigment used by van Gogh is faded (Vanmeert, F., G. Van der Snickt, and K. Janssens, Plumbonacrite Identified by X-ray Powder Diffraction Tomography as a Missing Link during Degradation of Red Lead in a Van Gogh Painting. Angewandte Chemie International Edition, 2015. 54(12): p. 3607-3610).

The impurities in the paint triggered a chemical reaction with the sunlight, and scientists found a rare lead-based mineral in the paint. This reacts with carbon dioxide from the air to create white crystals. It has also been found that a particular yellow pigment, i.e. cadmium yellow, reacts with sunlight and moisture, and degrades to another beige compound. The reaction can make the paint/color even fall off the canvas. Van Gogh's "Flowers in the Blue Vase", in particular, has been badly affected by this process (Geert Van der Snickt, Koen Janssens, Joris Dik, Wout De Nolf, Frederik Vanmeert, Jacub Jaroszewicz, Marine Cotte, Gerald Falkenberg, and Luuk Van der Loeff, Combined use of Synchrotron Radiation Based Micro-X-ray Fluorescence, Micro-X-ray Diffraction, Micro-X-ray Absorption Near-Edge, and Micro-Fourier Transform Infrared Spectroscopies for Revealing an Alternative Degradation Pathway of the Pigment Cadmium Yellow in a Painting by Van Gogh. Analytical Chemistry 2012, 84 (23), 10221-10228). Works by many artists are at risk even though they often seem to be well protected in museums or art galleries.

Solvents and varnishes that have long been used to protect artworks often prove to be destructive solutions. Resin-based systems for the protection of artworks exhibited in museums and galleries affect irreversibly the underlying surface of the work, while the specially used glass display cases are not capable of protecting the works adequately from the aforementioned damaging agents.

It is accordingly an object of the present invention to provide possibilities and means to protect artwork from especially UV radiation but also from visible light and artificial indoor illumination, but also from other detrimental environmental effects and damaging agents.

WO2020/141078 A1 discloses methods of art protection by applying a protective graphene coating onto the surface of the artwork or to colored surfaces to be preserved. However, in some instances it might be difficult or undesirable to apply a continuous protective graphene coating, especially in case of three-dimensional artwork having an irregular surface structure.

In museums and art galleries, illumination which emits UV light have often been exchanged for LED lights which give off hardly any UV rays. However, LED lights do not illuminate a painting as well as their incandescent predecessor light sources and very sophisticated engineering of LEDs is required to achieve a similar illumination effect compared to natural lighting. Such LEDs are expensive and the exchange of all illumination in all relevant circumstances by such LEDs will hardly be possible. Furthermore, other radiation than UV light also contribute to deterioration of artwork and fading of colors. Consequently, there is still a need for providing efficient and easily applicable protection for artwork, especially for upgrading existing means of protection in museums and art galleries.

### Summary of the invention

This object is solved by using efficientcoatings on protective shields or display cases. According to the present invention, such coatings are transparent 2D materials or derived therefrom. An noticeable protective effect was observed when e.g. a graphene coating was applied to a glassy surface as commonly used in museums and art galleries as either a protective shield or display case around paintings or other artwork. Furthermore, protective graphene coatings can also be applied to the windows of a building in which artwork is displayed, thus avoiding that UV radiation can enter from the outside. The same effect can be achieved with other 2D materials which are able to absorb UV radiation and other detrimental parts of visible light or artificial illumination and which materials can be provided in the form of atomic monolayers or in similar 2D configuration which does not impair the appearance and air of the artwork to the viewer.

In a first and preferred aspect, the present invention provides a use of a protective graphene coating for providing protection for a two- or three dimensional artwork or a colored surface against color degradation, especially fading, yellowing and discoloration, due to exposure to UV radiation or other radiation, the use comprising applying the graphene coating onto a glassy surface, which is or will be situated between the artwork and the source of radiation, by a method comprising the following steps:
a) depositing, preferably by chemical vapor deposition (CVD), graphene onto a at least one side of a supporting substrate to produce a graphene/substrate composite including a continuous graphene membrane formed on at least one side of said substrate;
b) removing the substrate, or lifting off the graphene from the substrate and
c) depositing the graphene membrane onto the surface.

In a second aspect, the present invention provides a protective screen or display case, which comprises a glassy material at least one surface of which is partly or fully covered by a protective graphene coating.

A third aspect of the present invention is the use of the protective screen or display case of the present invention or of a glassy surface including a protective layer of a graphene coating obtained by the method described herein for the protection of two- or three-dimensional art work or colored surfaces.

### Detailed description of the invention and preferred embodiments

The present invention discloses and provides an easily applicable and easily removable protective layer that can be applied onto a glassy surface which is e.g. used as a protective screen or frame, or several of which are used as display cases to preserve artwork. The present invention not only allows for an easy production of new protective screens or display cases but also allows to at a later time equip existing glass screens, window panes and display cases with protective coatings. Furthermore, the inventive method can be used to restore and rebuild protective layers on surfaces which are exposed to wear and abrasion of protective coatings due to e.g. cleaning measures. The inventors found that by using protective screens of the present invention as frames or encasement for paintings or for display cases for other subjects, artwork can reliably be protected from the detrimental influences of light emitted from different sources and from other ambient conditions. The same is true for situations in which existing protective shields or display cases are subsequently outfitted with a protective graphene coating. The graphene coating which according to the invention is a preferred aspect, provides for a very efficient protection of artwork when such protective screens or display cases are properly positioned and used to shield the artwork to be protected from the detrimental influence. Other 2D materials, as mentioned above, can be prepared and applied in a similar manner, e.g., hexagonal boron nitride (hBN), molybdenum disulfide (MoS₂) and tungsten disulfide (WS₂).

Since its discovery and isolation in 2004 by Geim and Novoselov which were awarded with the 2010 Nobel Prize in Physics, graphene has been considered as a "miracle material" due to its excellent chemical stability, its ability to conduct heat and electricity, and its overall excellent physical/mechanical properties. Graphene is one of the many allotropic forms of carbon and can be regarded as the absolute aromatic hydrocarbon, which exists as a single layer of carbon atoms, bonded together in a two-dimensional, sheet-like hexagonal structure that creates many unique properties. Graphene is practically impermeable to all known chemical substances even atomic hydrogen; thus it provides protection to underlying substrates against all gases inclusive of oxygen and also against water vapor. It also absorbs only 2.3% of visible light, which makes it practically invisible.

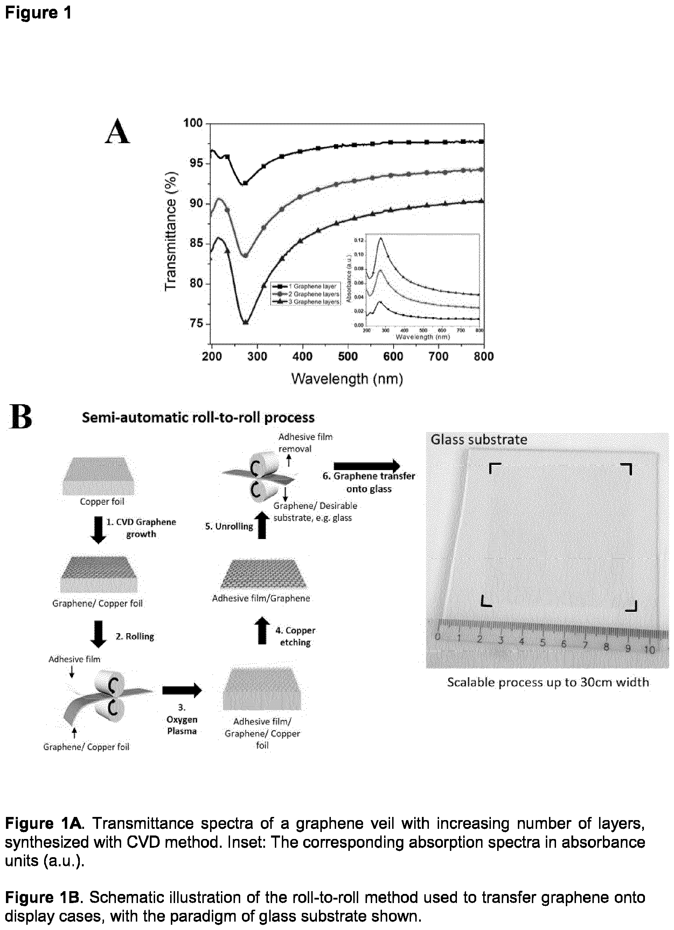

Graphene related materials have been found to provide significant shielding of the ultraviolet part of the electromagnetic spectrum as coatings, since a monolayer of graphene absorbs up to three times more in the UV region (190-400 nm) than in the visible region (figure 1A). In addition, it is known that chemical molecules such as water or oxygen cannot penetrate a continuous graphene membrane which accordingly provides complete protection against degradation caused by such molecules.

The present invention describes the development of an invisible "veil" such as a graphene membrane of atomic thickness on glassy surfaces that can provide additional protection against mostly UV radiation, but also against moisture, oxygen or any other chemical penetration of e.g. display cases. According to the invention, the protection of the artwork is achieved by producing and transferring appropriate sizes of graphene layers or layers of other corresponding 2D materials onto glassy surfaces, such as common glass or suitable polymeric glassy materials. Such protective layer can even be applied to larger three-dimensional structures for which similar protection is desired.

A schematic representation of an especially preferred embodiment of this first aspect of the inventive method and use is shown in figure 1B. According to this first aspect, a graphene membrane which preferably constitutes a graphene monolayer, is formed and transferred onto the surface to be protected. The various process steps and preferred embodiments will be described in more detail in the following.

Step a) of the inventive use includes depositing graphene onto at least one side of a supporting substrate to produce a graphene/substrate composite including a continuous graphene membrane formed on at least one side of said substrate. One preferred embodiment of step a) is represented by steps 1 to 4 in figure 1B. In this embodiment, graphene is first applied onto a copper foil to produce a graphene/Cu foil composite.

A chemical vapor deposition method is preferred for the synthesis of continuous graphene structures as the conditions of production can be controlled in such way as to yield graphene sheets that contain minimal defects such as cracks, gaps or holes. Other methods of applying graphene onto a substrate can also be used within the context of the invention as long as they create a (mostly) defect-free thin graphene layer, preferably a monolayer, however, in certain instances also a multilayered film can be useful.

As the supporting substrate, preferably a metal, polymer or other non-metal material, is used. Advantageously, this supporting substrate is in the form of a flexible sheet or foil. Most preferably, a copper foil or sheet is used as in figure 1B.

In another preferred embodiment of the inventive method, after step a), a further supporting layer is applied onto the graphene membrane-bearing side of the graphene/substrate composite. In such preferred embodiment, a layered composite is formed consisting of the graphene membrane enclosed by or sandwiched between the supporting layer and the supporting substrate. A polymer-based backing substrate or adhesive film can be conveniently used as the supporting layer. In an especially preferred embodiment, a pressure-sensitive adhesive film is used as the supporting layer. It is further preferred, to apply the supporting layer via a roll-to-roll coating process or by direct compression transfer (stamping). This preferred embodiment is exemplified as step 2 in figure 1B in which an adhesive film is applied to the graphene/Cu foil and fixated by applying pressure. As the polymer-based backing substrate or the adhesive film, a flexible and/or transparent material can be used, which preferably is selected from PET-, PMMA-, and PET/silicone films or membranes.

In a further preferred embodiment, after step a) and, preferably, after the additional step of applying a supporting layer onto the graphene membrane bearing side of the graphene/substrate composite, an oxygen plasma treatment is performed. This additional step is shown as step 3 in figure 1B. The oxygen plasma treatment removes graphene which, during the deposition of graphene onto the supporting substrate surface, was inadvertently deposited on the other (opposite) side of the substrate.

In step b) of the inventive method, the graphene membrane is separated from the supporting substrate. This separation can be performed by removing the substrate or by lifting off the graphene membrane from the substrate. In the first case, especially in the context of the preferred embodiment, in which a Cu foil or sheet is used as the supporting substrate and a further supporting layer was applied, this Cu material is conveniently removed by an etching treatment thus leaving a graphene/supporting layer composite. Such treatment is shown as step 4 in figure 1B.

Any further means or method to separate the composite of supporting layer/graphene/substrate by removing the supporting substrate can also be used within the context of the present invention. Furthermore, any further means or methods of removal or lifting off of the graphene membrane from a supporting substrate, on which the membrane was formed, is also applicable, especially in cases in which an additional supporting layer is not included.

In step c), the obtained graphene membrane is deposited onto the glassy surface. In a preferred embodiment, this deposition is performed via a roll-to-roll coating or unrolling process. This preferred embodiment is shown as steps 5 and 6 in figure 1B where a graphene/adhesive film composite is deposited on the glassy material and is attached thereto by applying pressure in the roll-to-roll process. As a second alternative, especially in cases in which the structure or size of the glassy surface prohibits such roll-to-roll coating, also a direct compression (stamping) method can be used to deposit the graphene membrane onto the glassy surface and to attach it thereto. The supporting layer can then easily be removed to result in a very thin protective graphene membrane layer on the glassy surface.

In a preferred embodiment of the invention, the roll-to-roll coating process or the unrolling process are performed under certain conditions which are listed in the following. The important conditions mainly include temperature, pressure and rolling speed. While the various conditions can be applied in combination, it is also possible to apply only one of the conditions as stated and to vary the other two, or to apply two of the stated conditions and to vary the third one. For temperature, the usually preferred range is 45 to 70°C, more preferably 50 to 55°C. For the pressure applied within the process, the preferred value is 0.1 to 10 MPa, more preferably from 0.1 to an upper value of 5, 2, 1 or 0.5 MPa. Preferably, the rolling speed is 0.1 to 5 mm/s, most preferably 0.015 to 0.035 mm/s.

Depending on the glassy surface and the dimensions thereof, a continuous graphene membrane is preferably applied, which has dimensions from a few centimeters up to some meters in length and width, and this membrane is deposited to fully or at least partially cover the glassy surface. Within the context of the present invention, it is further possible to apply a membrane consisting of a graphene monolayer, or multiple graphene layers can be used. If a multilayer graphene membrane is used, it can be prepared by depositing several graphene layers onto the supporting substrate in step a), or, alternatively, additional graphene layers can be applied to an adhesive film onto which already a first graphene layer has been deposited in the process as described above. Finally, it is also possible to apply the described methods multiple times to transfer multiple graphene membrane layers onto the glassy surface. In preferred embodiments, in step a) a continuous graphene monolayer or multilayer membrane is formed, and the membrane preferably has a thickness of 0.33 nm (monolayer) to n x 0.33 nm (multi-layered). As mentioned above, also a repeated application of the process or transferring of multiple membranes onto the supporting layer can result in a multi-layered graphene membrane

While the described method can be used to apply a protective coating onto any glassy surface, it is nevertheless preferred that the surface to be coated exhibits a surface roughness from 1 nm to 10 µm, preferably a surface roughness of between 80 and 120 nm. Furthermore, it is preferred that the surface has a surface energy of 1 to 100 mN/m, preferably at least 5, 10 or 15 mN/m and up to 90, 80 or 70 mN/m. An especially preferred range is 40 to 70 mN/m.

In a more detailed description of a preferred embodiment of the inventive use, a metal substrate (usually a copper sheet) is heated to a high temperature and exposed to precursor gases (hydrocarbons) which react on its surface, to result in a graphene coating on the metal substrate. Using basic starting materials such as methane (CH₄), the CVD method has the ability to produce high-quality graphene on a variety of supporting substrates such as metals (Cu, Ni etc.), polymers and non-metals. The process of transferring the graphene from a polymer-based backing substrate such as poly(ethylene terephthalate) (PET) or poly(methyl methacrylate) (PMMA) onto a glassy surface has been developed by the inventors. The roll-to-roll process allows for dry transfer of graphene CVD membranes (both monolayer and few-layers or multi-layers) onto a glassy surface as shown in figure 1B.

In further preferred embodiments of the invention, a continuous graphene membrane having dimensions from a few centimetres up to some meters is deposited to fully or at least partly cover the glassy surface. For example, a graphene membrane having dimensions of 10 to 20 cm in width and tailored to the size of the target glassy surface in length is produced and deposited onto the glassy surface. Optionally, more than one strips of membrane can be deposited in parallel if required to fully cover the glassy surface.

The glassy surface onto which a graphene membrane is deposited according to the present invention includes common glass, quartz glass or acrylic polymers like preferably poly(methyl methacrylate) (PMMA), a commercial glass already enhanced with anti--UV filters/coatings/films or any other material which is used as a display case or transparent protective shield especially in museums and art galleries.

According to further preferred embodiments of the invention the graphene membrane is deposited onto each side (or face) of the glassy surface or onto several glassy surfaces of a display case, preferably including both the outer and the inner surfaces.

The present invention is highly advantageous since it provides a protective coating on glassy surfaces which in turn can be used to protect artwork from fading of colors, but also form other detrimental environmental effects. Not only is the application of the graphene membrane onto the glassy surface easy to perform, even in a retrofitting process, but it is not necessarily permanent. The protective coating can be removed if required, e.g. if the coating has become unsightly due to wear or dirt accumulating thereon. The protective graphene membrane, mono- as well as multi-layered graphene membranes, can for example be removed dryly by means of a soft rubber eraser or similar methods of ablation without damaging the glassy surface itself, especially the optical integrity of the glassy surface. A new coating can then be applied and the protective effect be restored. An additional advantage is that the present invention provides protection at an affordable price since the required graphene quantities are minimal.

In a further aspect, the present invention relates to a protective screen or a display case which comprises a glassy material at least one surface of which is coated by a protective coating, preferably a graphene coating. In a preferred embodiment of the present invention, the protective screen or display case can be obtained by the method described above, i.e. by providing a graphene membrane on the glassy material from which the protective screen or the display case is made. As also mentioned above, protective screens of the present invention can be used for protecting artwork, especially paintings by applying a protective screen on top of a painting or at a certain distance to the painting, however in a manner to shield the painting from radiation, and preferably also in a manner to protect the painting from other environmental conditions which can be damaging to the painting. Especially in the latter case, a full encasing of the painting is especially appropriate in order to avoid that moisture, oxygen or other chemicals can penetrate the screen or casing.

In a preferred embodiment of the present invention, the glassy material is selected from common glass, quartz glass or acrylic polymers. And especially preferred acrylic polymer is poly(methyl methacrylate) (PMMA). Within the context of the present invention, also commercial glass can be considered as an appropriate glassy surface, which commercial glass is already enhanced with anti--UV filters/coatings/films. Furthermore, any other material which is or can be used as the display case or a transparent protective shield, especially in museums and art galleries, is included within the context of the present invention.

Also display cases of all kinds and sizes are used to appropriately protect artwork in its various forms. Such display cases include at least at one side a transparent material through which the artwork can be viewed. According to the present invention, such transparent material is a protective screen of a glassy material carrying at protective graphene coating on at least one side thereof. In especially preferred embodiments of the present invention, such protective screen can also be coated on both sides/surfaces thereof by protective graphene coating providing for even more enhanced protection. The display case can be manufactured by using protective screens of the present invention on all sides, but minimally one side of the display case is made from a protective screen material of the invention.

In special embodiments of the present invention, the protective screen further includes an additional layer of a glassy material, either the same material as the first mentioned glassy material, or a different applicable material. In such embodiment, the graphene is provided as an intermediate layer to achieve the creation of the sandwich laminated structure of glassy material - graphene - glassy material. Also such protective screens can be advantageously used for a building display cases showing an especially high protection, also against breaking.

It will be apparent to the skilled person that graphene coated glassy surfaces and protective screens and display cases according to the present invention have many advantages compared to currently used materials. As already mentioned above, protection is not only provided against damaging radiation of natural light or artificial illumination but also against moisture, dirt, dust, chemical and or oxidizing agents.

A further subject of the present invention is the use of a protective screen or display case of the present invention or of a glassy surface including a protective layer of the graphene coating obtained via the above described method for the protection of two- or three-dimensional artwork. Protection is provided against ultraviolet (UV) light, visible radiation (e.g. white/visible light emitted from LED lamps), moisture, dirt, dust, chemical and/or oxidizing agents as outlined above.

In further preferred embodiment, the protective screen is applied to a two-dimensional art work directly or spaced apart by an appropriate distance, e.g. 2 to 10 cm, or wherein one or several protective screens are used to construct a display case, especially for three-dimensional art work. Finally, a further use of the present invention includes the inventive use of applying a protective layer of a graphene coating onto existing windowpanes, e.g. in museums or at galleries, to protect against especially UV light.

The observations of the inventors during the development of the above described subjects showed that use of a protective graphene coating prepared and deposited according to the disclosed method leads to especially efficient protection provided by a corresponding glass screen to especially a two- or three-dimensional artwork or any colored surface, against color degradation, especially fading, yellowing and discoloration due to exposure to UV radiation. It also provides additional protection against accumulation of dirt or dust, or a negative influence by moisture as well as chemical and/or oxidizing agents contained in the environment surrounding the artwork or colored surface. Furthermore, these observations led to the development of protective screens and display cases onto at least one surface of which a protective graphene coating has been deposited. Finally, the inventive use of a protective graphene coating is also applicable to existing screens or window panes or all other transparent and glassy surfaces which benefit from additional UV- or other radiation protective properties.

The following figures and examples are provided to further illustrate the invention.

### Description of the figures

The included figures show the following:
Figure 1A: transmittance spectra of the graphene way you with increased number of layers, synthesized with CVD method. Inset: the corresponding absorption spectra in absorbance units (a. U.).
Figure 1B: schematic illustration of the roll-to-roll method used to transfer graphene onto display cases, with the paradigm of glass substrate shown.
Figure 2: the fluctuation of several parameters related to the growth of CVD graphene onto copper foil.
Figure 3: final configuration for the laminator. The modified laminator was the basic instrument for dry roll-2 roll graphene transfer onto display cases.
Figure 4: pictures of graphene on PET/Silicon transfer medium (a), on glass (b) and on PET/EVA (c) (single graphene layer), (d) (bilayer graphene).
Figure 5: Assessment of graphene quality after roll-to-roll transfer. a) Typical Raman spectra of graphene transferred on PET-EVA and on glass. Graphene characteristic peaks are marked with asterisks. b) Schematic of the mapping protocol for cm-size graphene specimens [2]. c) Statistical analysis of Raman mapping on transferred graphene: 2D/G intensity ratio for each mapping location. d) Representative AFM topography of monolayer CVD graphene transferred on glass.
Figure 6: Sessile drop technique using water was applied for examining the hydrophilicity/hydrophobicity of the coated with monolayer graphene glass substrate. It is observed that after graphene deposition, the contact angle increases by approximately 20°, turning the treated-glass substrate from hydrophilic to hydrophobic. The water droplet on the graphene edge - in contact partially with graphene/glass area is depicted.
Figure 7. Contact angle mapping with water droplets.
Figure 8. Water vapour permeability of PET-EVA coated with 1 and 2 layers of graphene, compared to neat PET/EVA. Also, comparison to neat PET/Si membrane to a monolayer graphene-coated PET/Si membrane.
Figure 9A. Left: A commercial glass used for display cases manufacturing, branded as *"FLABEG ARTControl UV60",* and, right: the same "museum" glass with a single graphene layer deposited on it.
Figure 9B. Ultra-violet and visible transmittance spectra for "museum glass" with and without a monomlayer of graphene.
Figure 10 shows protection factors for the commercial museum glass and the same coated with single layer graphene.

### Examples

### Example 1

### Production of graphene veils

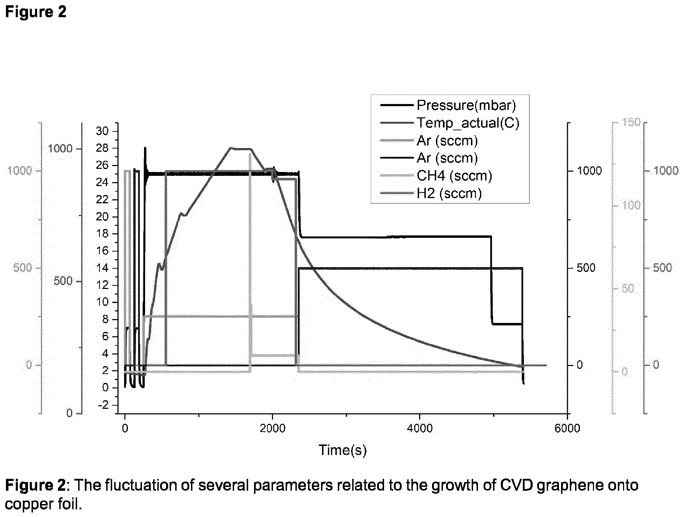

The graphene monolayers are synthesized on copper foils in an AIXTRON^{®} BM Pro CVD chamber. A high quality copper substrate supplied by Viohalco^{®} was used as the catalyst substrate. For the graphene production, the foil is cut into 7 x 7 cm2, cleaned by isopropanol to remove any organic contamination and introduced into CVD chamber. After the closure of the chamber, it is immediately pumped down to 0.1 mbar and then a mixture of argon/hydrogen (Ar/H₂) gases is introduced (250 sccm/50 sccm) with a pressure below 25 mbar. The foil is heated in 1000°C and is kept there for 5 min for annealing. Afterwards the sample is cooled down to 925°C, while methane (CH₄) is introduced into chamber (10 sccm) as carbon feedstock to initiate the graphene growth on copper foil surface. After 5 min, the H₂ flow is terminated, the chamber is cooled down to 650°C and the CH₄ flow is also terminated. Then the chamber is cooled down to room temperature under an Ar atmosphere. ***Figure** 2* illustrates the fluctuation of applied pressure, temperature and gases flow.

### Example 2

### Graphene transfer method

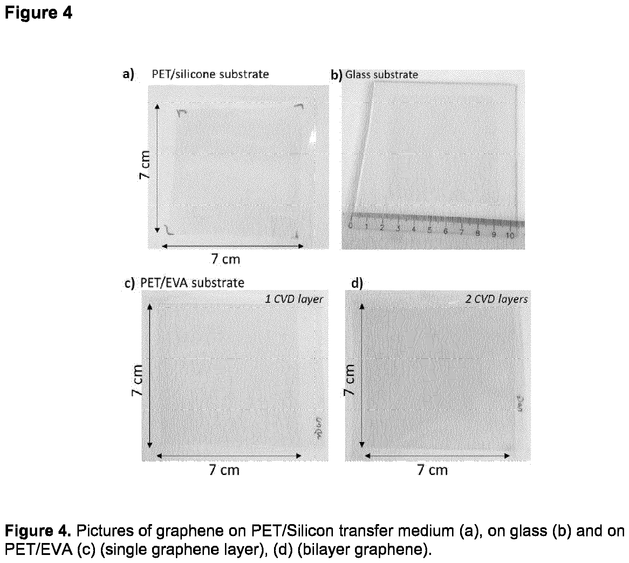

The roll-to-roll method (Kim, S.J., et al., Ultraclean Patterned Transfer of Single-Layer Graphene by Recyclable Pressure Sensitive Adhesive Films. Nano Letters, 2015. 15(5): p. 3236-3240*)* without the use of solvents or chemicals is ideal for graphene deposition without damaging the artworks. For that reason, a tailor-made roll-to-roll machine based on a commercial laminator was designed and built. The whole procedure is shown in ***Figure** 1B**.* Firstly, CVD graphene is cleaned from dust, dirt or/and water molecules by purging nitrogen gas on its surface. Then, the specimen is attached to one side of a commercial flexible PET/Silicone membrane by employing the roll-to-roll machine (***Figure 4***)*,* at a rolling speed of 0.195-0.325 mm/sec and pressure of 0.1-0.5 MPa. The PET/Silicone film was chosen as a backing substrate because it adheres well to the copper sheet with the graphene on top of it and is transparent and flexible. Also, it is resistant to aggravating agents of subsequent processing steps (oxygen plasma, etching, and pressure - transfer temperature). Then, the graphene deposited on the other side of the membrane is removed by oxygen plasma. Subsequently a water solution of 0.1 M ammonium persulfate is used to etch the copper, and afterwards, deionized water is used to clean any remaining dirt or residue of the ammonium persulfate. The PET/Silicone/graphene membrane is left for at least 8 hours inside a vacuum chamber in order to be de-hydrated. Afterwards, the membrane is ready to be transferred onto paper substrate. For the graphene transfer, the reverse procedure of rolling, i.e. unrolling (***Figure 1B***)*,* is performed, using the same parameters indicated above, at a temperature of 50-55°C. For the deposition of bi-, tri- or multi-layered membranes, we iterated the same procedure so to have non-Bernal stacked multilayers.

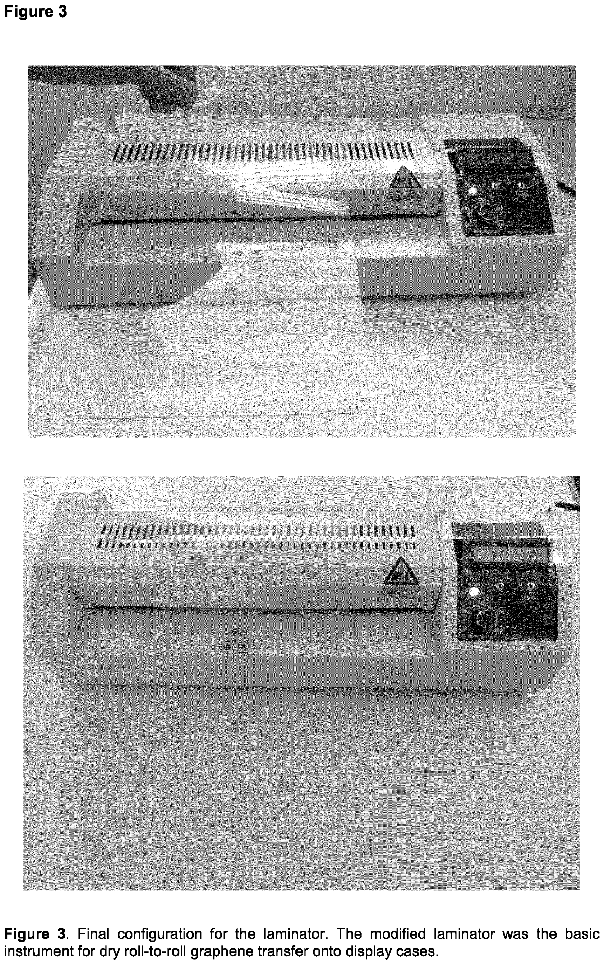

The dry transfer method is based on the use of pressure-sensitive adhesive films (PSAF), like the PET/Silicone membrane as supporting layer. It takes advantage of the difference in wettability and adhesion energy of graphene with respect to PSAF and the target substrate. Then, the PSAF layer is simply peeled off from the target substrate, thus leaving the graphene membrane on the substrate. The basic parameters which define the success of the transfer process are estimated to be the transfer rate, temperature and pressure. Empirically, we have observed that the lower the transfer rate, the more effective the graphene transfer is. Finally, it was observed that mild heating to 50-55°C has positive effect on the transfer quality. Such an effect is attributed to the change of surface properties of PET/Silicone since its surface energy decreases by the thermal treatment. For the graphene membranes, the transfer process must be performed at a slow rate to ensure the homogeneous heating to the desirable temperature by the laminator's rollers of graphene and the substrates. Regarding the transfer pressure, it is noticed that application of high pressure between the rollers results in a homogeneously transferred graphene film. Hence, the design of the laminator has been performed based on the above parameters and findings. A commercial cold/hot laminator FJK 320 was modified in order to be used as the roll-to-roll transfer system. The system could operate up to 180°C and the initial motor's speed was 3.5 rpm which corresponds to a linear velocity of 9.2 mms⁻¹, since the rollers' diameter is 2.5 cm. The measured speed was much higher than that required for the given application, so the initial motor was replaced by the NEMA-17 stepper motor with an integrated planetary gearbox with a 99.51:1 drive ratio. The final configuration of the as-modified laminator is presented as ***Figure 3****.*

### Example 3

### Transfer of Graphene onto Display Cases

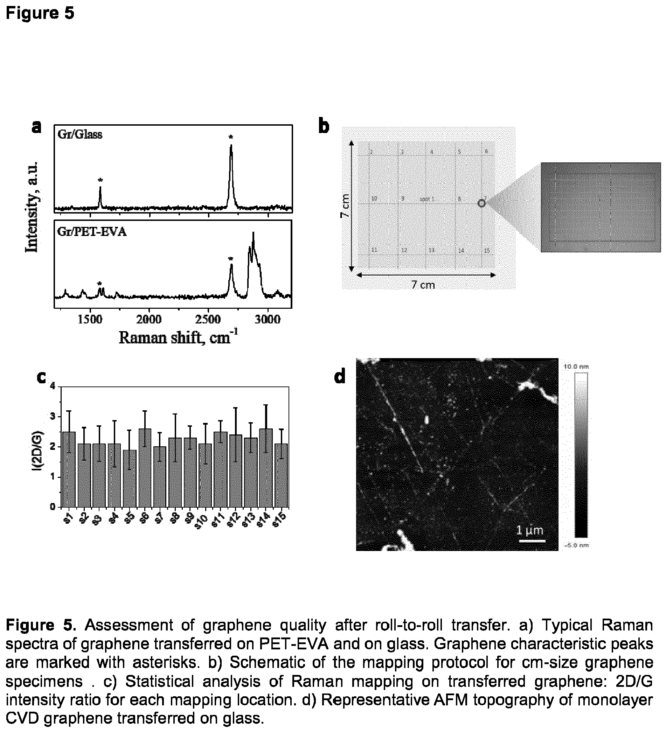

The dry transfer method and pictures of graphene transferred on both glass and PET-based films are depicted in ***Figure 4****.* It is interesting noting here that in all the produced samples (***Figure 4******, a to* c**), the presence of monolayer graphene is barely seen by naked eye as it is known that it brings about only a 2.3% reduction in transmittance [D.E. Sheehy and J.Schmalian, Phys. Rev. B 80, 193411 (2009)]. Also, any major cracks or fissures in the investigated samples could not be located. Representative Raman spectra of transferred graphene on PET and on glass are presented in ***Figure 5a****,* where the negligible D peak intensities and the large 2D/G peak ratio indicate that the transferred CVD graphene still retain the high-quality monolayer character, as also evidenced by statistical analysis of Raman mapping *(**Figure 5c**)* performed in several locations of the cm-size specimens (***Figure 5b***)*.* AFM topography (***Figure 5d***) of transferred graphene shows typical features of CVD-grown graphene, in particular wrinkles and small amount of debris probably left by the PET/Silicon transfer medium adopted in the roll-to-roll procedure.

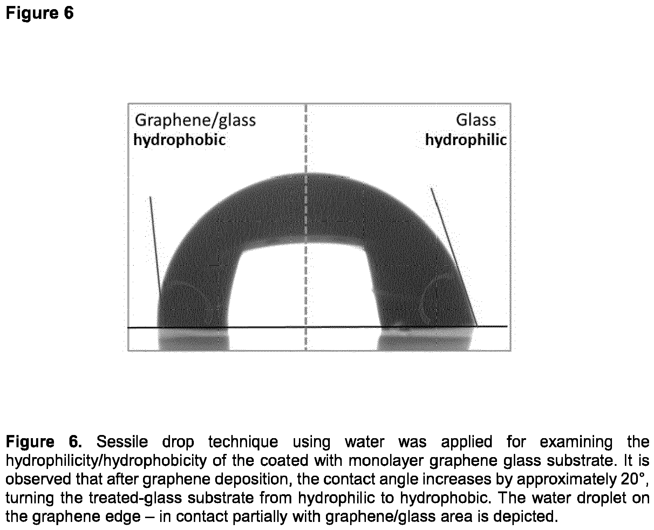

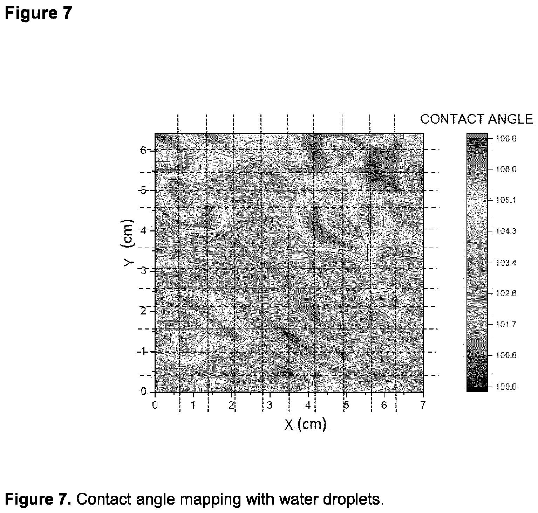

A KRUSS DSA 100 contact angle meter was used for performing contact angle measurements with water as the tested liquid, on the sample of ***Figure** 4b**.* Sessile drop technique was applied while each measurement on each point of the as-examined sample was taken three times and the average values are reported. A whole scanning of the sample regarding its wettability was conducted in order for our group to observe hydrophilicity/hydrophobicity of the coated sample but also detect possible cracks or defects of graphene during the transfer procedure, since it is known that graphene is a hydrophobic material [A. Kozbial et al. Langmuir (2014), Vol. 30, pages 8598-8606]. A possible large deviation of contact angle values in specific areas of the sample could reveal an unsuccessful graphene transfer. For monolayer graphene, a contact angle of water of the order of 95-100° is expected [Taherian et al., Langmuir 29, 1457-1465 (2013)]. ***Figures* 6** **and** **7** reveal a transition from hydrophilicity shown by neat glass substrate to hydrophobicity in graphene-coated glass. It is interesting noting that, in measurements performed at the border area glass-graphene, the shape of the sessile drop is not symmetric. In particular, for neat glass the contact angle is equal to 81° and for graphene-coated glass, the contact angle is 103°. The spatial mapping reveals that contact angle values higher than 100° can be found homogeneously across the whole surface of the sample and, since 90° is considered a threshold value for hydrophobicity, the treated with graphene surface is hydrophobic.

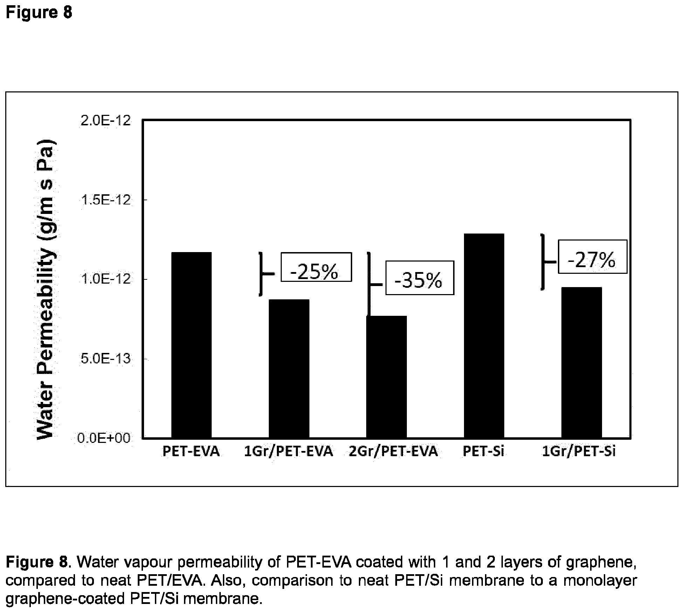

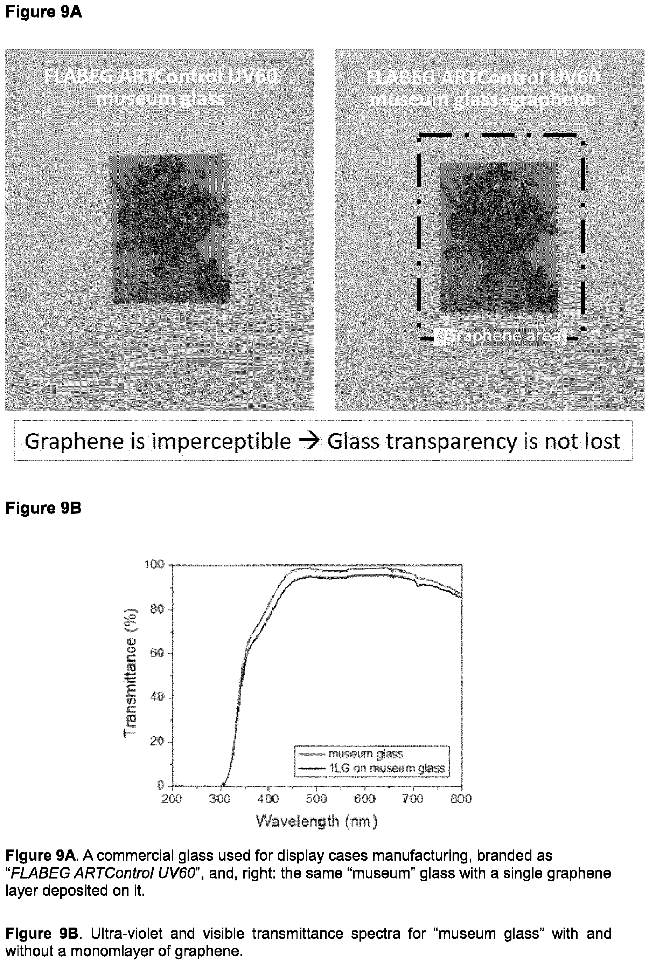

Water vapour permeability was determined using the infrared sensor technique by means of a PermatranW3/31 (Mocon, Germany). Samples with a surface area of 5 cm² were tested at 25°C. Permeation tests were performed by setting the relative humidity at the downstream and upstream sides of the film to 0% and to 50% respectively. A flow rate of 100 ml/min of a nitrogen stream was used. Each test was carried out in duplicate. Water vapour permeability measurements were performed on graphene on PET-EVA and PET/Silicone samples at 50% RH and 25°C and results are shown in ***Figure** 8**.* It is interesting noting that the presence of graphene induces a reduction of permeability of ∼25% for PET-EVA covered with single layer graphene, of ∼35% for PET-EVA covered with bilayer graphene, and, of 27% for monolayer graphene onto PET/Si, all compared to the neat corresponding polymers. ***Figure* 9** ***A*** and B shows that graphene does not induce an unacceptable optical difference after its deposition onto a commercial "museum" glass. Rather, a reduction of transmittance of only 2,3% was observed.

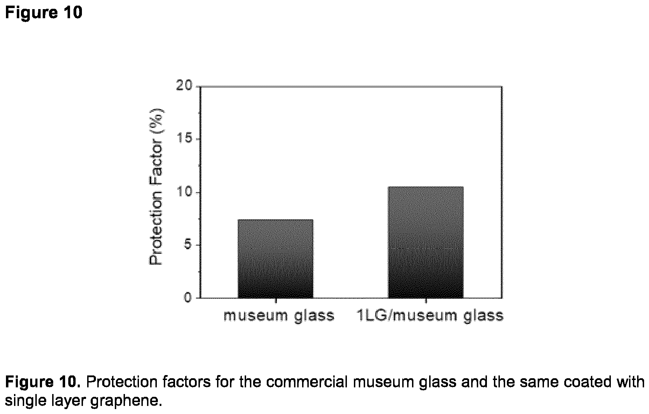

Typical aging experiments were performed to assess the effectiveness of graphene-coated glasses to protect colours from fading compared to bare glass. Experiments have been performed under visible light, as museum glasses are likely to block most of the UV radiation. Upon aging for two weeks of coloured papers behind the glasses, it was found that bare glass offers a protection factor of 7.38% against visible radiation, while graphene-coated glass shows an improved performance, with a PF of 10.45% (***Figure 10*****)*.*** This 40% increase of PF obtained by the graphene addition is remarkable and demonstrates that graphene- enhanced glasses can be employed in cases in which either the substrate is extremely rough or the artwork is invaluable (e.g. Old Masters' paintings) and, therefore, physical "contact" with the graphene protection layer is not recommended.
In summary of the above, the following items are described in the present patent application:

### Item 1.

Use of a protective graphene coating for providing protection for a two- or three dimensional artwork or a colored surface against color degradation, especially fading, yellowing and discoloration, due to exposure to UV radiation or other radiation, the use comprising applying the graphene coating onto a glassy surface, which is or will be situated between the artwork and the source of radiation, by a method comprising the following steps:
a) depositing, preferably by chemical vapor deposition (CVD), graphene onto a at least one side of a supporting substrate to produce a graphene/substrate composite including a continuous graphene membrane formed on at least one side of said substrate;
b) removing the substrate, or lifting off the graphene from the substrate and
c) depositing the graphene membrane onto the surface.

### Item 2.

Use according to item 1, wherein as the supporting substrate a metal, polymer or non-metal material, preferably in the form of a flexible sheet or foil material, is used.

### Item 3.

Use according to item 1 or 2, further comprising:
after step a), applying a supporting layer onto the graphene membrane bearing side of the graphene/substrate composite to produce a supporting layer/graphene/substrate composite.

### Item 4.

Use according to item 3, wherein as the supporting layer a polymer-based backing substrate or adhesive film, preferably a pressure-sensitive adhesive film, is used, and/or wherein applying the supporting layer is performed via a roll-to-roll coating process or by direct compression transfer (stamping).

### Item 5.

Us e according to item 4, wherein as the polymer-based backing substrate or the adhesive film a flexible and/or transparent material is used, which preferably is selected from PET-, PMMA-, and PET/silicone films or membranes.

### Item 6.

Use according to anyone of items 1 to 5, wherein a Cu foil or sheet is used as the supporting substrate which, in step b), is removed by an etching treatment or the graphene is lifted off from the substrate by suitable means.

### Item 7.

Use according to anyone of items 1 to 6, wherein additionally an oxygen plasma treatment is performed after step a).

### Item 8.

Use according to anyone of items 1 to 7, wherein, in step c), depositing of the graphene membrane onto the glassy surface is performed via a roll-to-roll coating or unrolling process.

### Item 9.

Use according to item 8, wherein the roll-to-roll coating or unrolling process is performed under at least one of the following conditions:
a temperature of 45 to 70°C, preferable 50 to 55°C, a pressure of 0.1 to 10 MPa, preferably 0.1 to 0.5 MPa, and a rolling speed of 0.1 to 5 mm/sec, preferably 0.015 to 0.035 mm/sec.

### Item 10.

Use according to anyone of the preceding items, wherein a mono- or a multi-layered graphene membrane is deposited onto the glassy surface(s).

### Item 11.

Use according to anyone of items 1 to 10, wherein in step a) a continuous graphene monolayer or multilayer membrane is formed, the membrane preferably having a thickness of from 0.33 nm (monolayer) to n x 0.33 nm (multilayer).

### Item 12.

Use according to anyone of items 1 to 11, wherein as the protective graphene coating a continuous graphene membrane having dimensions from a few centimeters up to some meters is deposited to fully or at least partially cover the surface

### Item 13.

Use according to item 12, wherein a graphene membrane having dimensions of 10 to 20 cm in width and tailored to the size of the target glassy surface in length is produced and deposited onto the glassy surface, wherein optionally more than one strips of membrane are deposited in parallel if required to fully cover the glassy surface.

### Item 14.

Use according to anyone of items 1 to 13, wherein the glassy surface is a common glass, quartz glass, or acrylic polymers like preferably poly(methyl methacrylate) (PMMA), a commercial glass already enhanced with anti-UV filters/coatings/films or any other material which is used as a display case or transparent protective shield especially in museums and art galleries.

### Item 15.

Use according to anyone of the preceding items, wherein the graphene membrane is deposited onto each side (or face) of the glassy surface or onto several glassy surfaces of a display case, preferably including both the outer and the inner surfaces.

### Item 16.

Use according to anyone of the preceding items for the production of a protective screen or display case for the protection of two- or three-dimensional artwork.

### Item 17.

Protective screen or display case which comprises a glassy material at least one surface of which is coated by a protective graphene coating.

### Item 18.

Protective screen or display case according to item 17, wherein the glassy material is selected from common glass, quartz glass or acrylic polymers like preferably poly(methyl methacrylate) (PMMA), a commercial glass already enhanced with anti--UV filters/coatings/films or any other material which is used as a display case or transparent protective shield especially in museums and art galleries.

### Item 19.

Protective screen or display case according to items 17 or 18, wherein the glassy material is coated with a protective graphene coating via a method as described in anyone of items 1 to 16.

### Item 20.

Protective screen or display case according to anyone of items 17 to 19, in which graphene constitutes an intermediate layer and which comprises a sandwich laminated structure of glassy material - graphene - glassy material.

### Item 21.

Use of a protective screen or display case according to anyone of items 17 to 20 for the protection of two- or three-dimensional artwork.

### Item 22.

Use according to item 21, wherein protection is provided against ultraviolet (UV) light, visible radiation (e.g. white/visible light emitted from LED lamps), moisture, dirt, dust, chemical and/or oxidizing agents.

### Item 23.

Use according to item 21 or 22, wherein the protective screen is arranged directly on two-dimensional artwork or spaced apart, e.g. by 2 to 10 cm, or wherein several protective screens are used to construct a display case, especially for the protection of three-dimensional artwork.

### Item 24.

Use according to item 21, wherein the protective screen, especially a protective screen according to item 20, is used as a window pane, especially for museums and art galleries.

## Claims

1. Use of a protective graphene coating for providing protection for a two- or three dimensional artwork or a colored surface against color degradation, especially fading, yellowing and discoloration, due to exposure to UV radiation or other radiation, the use comprising applying the graphene coating onto a glassy surface, which is or will be situated between the artwork and the source of radiation, by a method comprising the following steps:
a) depositing, preferably by chemical vapor deposition (CVD), graphene onto a at least one side of a supporting substrate to produce a graphene/substrate composite including a continuous graphene membrane formed on at least one side of said substrate;
b) removing the substrate, or lifting off the graphene from the substrate and
c) depositing the graphene membrane onto the surface.

2. Use according to claim 1, wherein as the supporting substrate a metal, polymer or non-metal material, preferably in the form of a flexible sheet or foil material, is used.

3. Use according to claim 1 or 2, further comprising:
after step a), applying a supporting layer onto the graphene membrane bearing side of the graphene/substrate composite to produce a supporting layer/graphene/substrate composite.

4. Use according to claim 3, wherein as the supporting layer a polymer-based backing substrate or adhesive film, preferably a pressure-sensitive adhesive film, is used, and/or wherein applying the supporting layer is performed via a roll-to-roll coating process or by direct compression transfer (stamping), preferably wherein as the polymer-based backing substrate or the adhesive film a flexible and/or transparent material is used, which preferably is selected from PET-, PMMA-, and PET/silicone films or membranes.

5. Use according to anyone of claims 1 to 4, wherein a Cu foil or sheet is used as the supporting substrate which, in step b), is removed by an etching treatment or the graphene is lifted off from the substrate by suitable means.

6. Use according to anyone of claims 1 to 5, wherein additionally an oxygen plasma treatment is performed after step a).

7. Use according to anyone of claims 1 to 6, wherein, in step c), depositing of the graphene membrane onto the glassy surface is performed via a roll-to-roll coating or unrolling process, preferably wherein the roll-to-roll coating or unrolling process is performed under at least one of the following conditions: a temperature of 45 to 70°C, preferable 50 to 55°C, a pressure of 0.1 to 10 MPa, preferably 0.1 to 0.5 MPa, and a rolling speed of 0.1 to 5 mm/sec, preferably 0.015 to 0.035 mm/sec.

8. Use according to anyone of the preceding claims, wherein a mono- or a multi-layered graphene membrane is deposited onto the glassy surface(s).

9. Use according to anyone of claims 1 to 8, wherein in step a) a continuous graphene monolayer or multilayer membrane is formed, the membrane preferably having a thickness of from 0.33 nm (monolayer) to n x 0.33 nm (multilayer).

10. Use according to anyone of claims 1 to 9, wherein as the protective graphene coating a continuous graphene membrane having dimensions from a few centimeters up to some meters is deposited to fully or at least partially cover the surface, preferably wherein a graphene membrane having dimensions of 10 to 20 cm in width and tailored to the size of the target glassy surface in length is produced and deposited onto the glassy surface, wherein optionally more than one strips of membrane are deposited in parallel if required to fully cover the glassy surface.

11. Use according to anyone of claims 1 to 10, wherein the glassy surface is a common glass, quartz glass, or acrylic polymers like preferably poly(methyl methacrylate) (PMMA), a commercial glass already enhanced with anti-UV filters/coatings/films or any other material which is used as a display case or transparent protective shield especially in museums and art galleries.

12. Use according to anyone of the preceding claims, wherein the graphene membrane is deposited onto each side (or face) of the glassy surface or onto several glassy surfaces of a display case, preferably including both the outer and the inner surfaces.

13. Use according to anyone of the preceding claims for the production of a protective screen or display case for the protection of two- or three-dimensional artwork.

14. Protective screen or display case which comprises a glassy material at least one surface of which is coated by a protective graphene coating, preferably wherein the glassy material is selected from common glass, quartz glass or acrylic polymers like preferably poly(methyl methacrylate) (PMMA), a commercial glass already enhanced with anti-UV filters/coatings/films or any other material which is used as a display case or transparent protective shield especially in museums and art galleries, and/or preferably wherein the glassy material is coated with a protective graphene coating via a method as described in anyone of claims 1 to 13.

15. Protective screen or display case according to claim 14, in which graphene constitutes an intermediate layer and which comprises a sandwich laminated structure of glassy material - graphene - glassy material.
